# FASCICULE DE BREVET EUROPEEN

(11) **EP 2 002 424 B1**
(45) Date de publication et mention de la délivrance du brevet: **29.07.2015**
(21) Numéro de dépôt: 07731713.9
(22) Date de dépôt: 08.03.2007
(51) Int. Cl.: G10L 19/008, G10L 19/24

(54) **DISPOSITIF ET PROCEDE DE CODAGE SCALABLE D'UN SIGNAL AUDIO MULTI-CANAL SELON UNE ANALYSE EN COMPOSANTE PRINCIPALE**
VORRICHTUNG UND VERFAHREN ZUR SKALIERBAREN KODIERUNG EINES MEHRKANALIGEN AUDIOSIGNALS AUF DER BASIS EINER HAUPTKOMPONENTENANALYSE
DEVICE AND METHOD FOR SCALABLE ENCODING OF A MULTICHANNEL AUDIO SIGNAL BASED ON A PRINCIPAL COMPONENT ANALYSIS

(30) Priorité: 15.03.2006 FR 0650883
(43) Date de publication de la demande: 17.12.2008
(73) Titulaire: Orange, 75015 Paris (FR)
(72) Inventeur: BRIAND, Manuel, 18268 Djursholm (SE); VIRETTE, David, F-22560 Pleumeur Bodou (FR)
(74) Mandataire: de la Fouchardière, Marie-Noëlle
(86) Numéro de dépôt international: PCT/FR2007/050897
(87) Numéro de publication internationale: WO 2007/104883

(56) Documents cités:
- WO-A-03/085645
- WO-A2-2004/086817
- VAN DER WAAL R G ET AL: "Subband coding of stereophonic digital audio signals" SPEECH PROCESSING 2, VLSI, UNDERWATER SIGNAL PROCESSING. TORONTO, MAY 14 - 17, 1991, INTERNATIONAL CONFERENCE ON ACOUSTICS, SPEECH & SIGNAL PROCESSING. ICASSP, NEW YORK, IEEE, US, vol. VOL. 2 CONF. 16, 14 avril 1991 (1991-04-14), pages 3601-3604, XP010043648 ISBN: 0-7803-0003-3

## Description

### Domaine technique de l'invention

L'invention se rapporte au domaine du codage par analyse en composante principale d'un signal audio multi-canal pour des transmissions audionumériques sur divers réseaux de transmission à différents débits. Plus particulièrement, l'invention vise à permettre un codage gradué (scalable en anglais) en débit pour s'adapter aux contraintes du réseau de transmission ou pour permettre un rendu audio dont la qualité est variable.

### Arrière-plan de l'invention

Dans le cadre du codage des signaux audio multicanaux, deux approches sont particulièrement connues et utilisées.

La première et plus ancienne consiste à matricer les canaux du signal multi-canal original de manière à réduire le nombre de signaux à transmettre. A titre d'exemple, le procédé de codage audio multi-canal Dolby^{®} Pro Logic^{®} II réalise le matriçage des six canaux d'un signal 5.1 en deux signaux à transmettre. Plusieurs types de décodage peuvent être réalisés de façon à reconstruire au mieux les six canaux originaux.

La seconde approche, appelée codage audio paramétrique, se base sur l'extraction de paramètres de spatialisation pour reconstituer la perception spatiale de l'auditeur. Cette approche se base principalement sur un procédé appelé « Binaural Cue Coding » (BCC) qui vise d'une part à extraire puis coder les indices de la localisation auditive et d'autre part à coder un signal monophonique ou stéréophonique issu du matriçage du signal multi-canal original.

En outre, il existe une approche hybride des deux approches ci-dessus basée sur une méthode appelée « Analyse en Composante Principale » (ACP). En effet, l'ACP peut être vue comme un matriçage dynamique des canaux du signal multi-canal à coder. Plus précisément, l'ACP est obtenue par une rotation des données dont l'angle correspond à la position spatiale des sources sonores dominantes du moins pour le cas stéréophonique. Cette transformation est d'ailleurs considérée comme la méthode de décorrélation optimale qui permet de compacter l'énergie des composantes d'un signal multi-composantes. Un exemple de codage audio stéréophonique à base d'ACP est divulgué dans les documents WO 03/085643 et WO 03/085645.

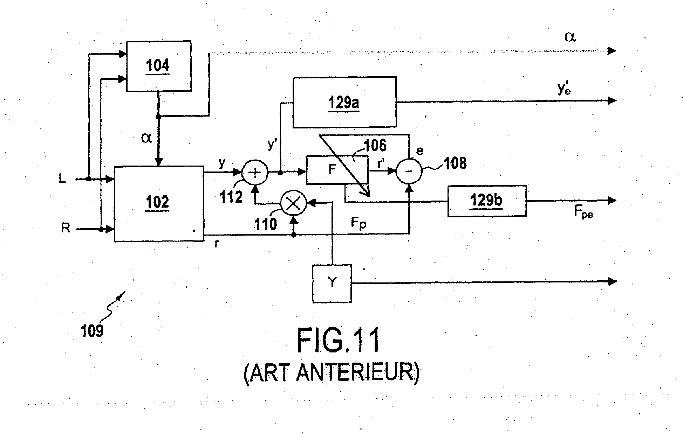

En effet, la figure 11 est une vue schématique illustrant un encodeur 109 pour le codage stéréophonique à base d'ACP selon l'art antérieur ci-dessus.

Cet encodeur 109 réalise un filtrage adaptatif des composantes issus de l'ACP du signal stéréo original comportant les canaux L et R.

L'encodeur comprend des moyens de rotation 102, des moyens ACP 104, des moyens de filtrage de prédiction 106, des moyens de soustraction 108, des moyens de multiplication 110, des moyens d'addition 112, des premiers et seconds moyens de codage audio 129a et 129b.

Les moyens de rotation 102 réalisent une rotation des canaux L et R selon un angle a définissant ainsi une composante principale y et une composante résiduelle r. L'angle a est déterminé par les moyens ACP 104 de sorte que la composante principale y présente une énergie plus forte que celle de la composante résiduelle r.

Les moyens de multiplication 110 multiplient la composante résiduelle r par un scalaire y. Le résultat de la multiplication ry est ajouté par les moyens d'addition 112 à la composante principale y. Le résultat de l'addition ry+ y est introduit dans les moyens de filtrage de prédiction 106.

Le paramètre de filtrage Fₚ qui définissent les moyens de filtrage de prédiction 106 est codé par les seconds moyens de codage 129b pour générer un paramètre de filtrage codé Fₚₑ.

Par ailleurs, le résultat de l'addition ry+ y est également codé par les premiers moyens de codage 129a pour générer une composante principale codée yₑ.

Ainsi, la méthode consiste à déterminer les paramètres des moyens de filtrage de prédiction tels que ces moyens de filtrage puisse générer une estimation de la composante résiduelle r issue de l'ACP à partir de la composante principale y qui est la plus énergétique.

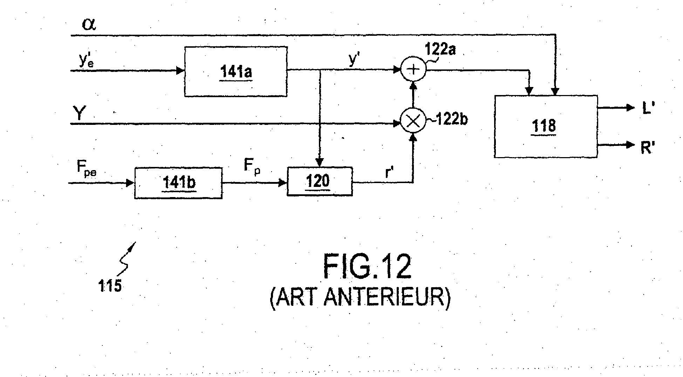

La figure 12 est une vue schématique illustrant un décodeur 115 pour le décodage d'un signal stéréophonique codé par l'encodeur de la figure 11.

Le décodeur 115 comprend des premiers et seconds moyens de décodage 141a et 141b, des moyens de filtrage 120, des moyens de rotation inverse 118 et des moyens d'addition et de multiplication 122a et 122b.

Le décodeur 115 réalise alors l'opération inverse en décodant la composante principale y'ₑ par les premier moyens de décodage 141a formant une composante principale décodée y', puis en réalisant son filtrage par les moyens de filtrage 120 en une composante résiduelle filtrée r' à partir des paramètres de filtrages Fₚ.

Les moyens de multiplication 122b multiplient la composante résiduelle filtrée r' avec le scalaire y formant le produit r'γ. Les moyens d'addition 122a permettent de soustraire r'y de la composante principale décodée y'.

Les moyens de rotation inverse 118 appliquent la matrice de rotation inverse en fonction de l'angle de rotation a aux signaux y' et r' pour générer les canaux L'et R' du signal stéréophonique décodé.

L'article "Subband coding of stereophonic digital audio signals", van der Waal R G et al, ICASSP 1991, divulgue un procédé de codage d'un signal audio comprenant une transformation par analyse en composante principale du signal audio en une composante principale et une sous-composante résiduelle par rotation.

Cependant, l'ACP réalisée selon l'art antérieur ne permet pas l'obtention d'une caractérisation fine des signaux à coder.

### Objet et résumé de l'invention

L'invention est revendiquée aux revendications indépendantes 1, 7 et 10 à 17. Les revendications dépendantes 2 à 6, 8 et 9 revendiquent des modes de réalisation.

### Brève description des dessins

D'autres particularités et avantages de l'invention ressortiront à la lecture de la description faite, ci-après, à titre indicatif mais non limitatif, en référence aux dessins annexés, sur lesquels :
- la figure 1 est une vue schématique d'un système de communication comprenant un dispositif de codage et un dispositif de décodage;
- la figure 2 est une vue schématique d'un encodeur;
- la figure 3 est une vue schématique d'un décodeur;
- les figures 4 7 sont des vues schématiques des encodeurs et décodeurs selon des modes de réalisation particuliers de l'invention ;
- les figures 8 et 9 sont des vues schématiques des encodeurs;
- la figure 10 est une vue schématique d'un système informatique mettant en oeuvre l'encodeur et le décodeur selon les figures 1 à 9, et
- les figures 11 et 12 sont des vues schématiques des encodeurs et décodeurs selon l'art antérieur.

### Description détaillée de modes de réalisation

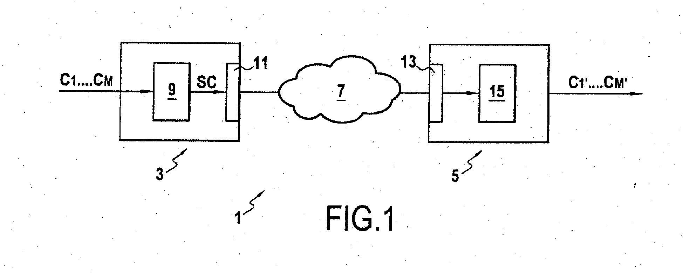

Conformément à l'invention, la figure 1 est une vue schématique d'un système de communication 1 comprenant un dispositif de codage 3 et un dispositif de décodage 5. Les dispositifs de codage 3 et de décodage 5 peuvent être reliés entre eux par l'intermédiaire d'un réseau ou ligne de communication 7.

Le dispositif de codage 3 comprend un encodeur 9 qui en recevant un signal audio multi-canal C₁,...,C_{M} génère un signal audio codé SC représentatif du signal audio multi-canal C₁,...,C_{M} original.

L'encodeur 9 peut être connecté à un moyen de transmission 11 pour transmettre le signal codé SC via le réseau de communication 7 au dispositif décodage 5.

Le dispositif de décodage 5 comprend un récepteur 13 pour recevoir le signal codé SC transmis par le dispositif de codage 3. En outre, le dispositif de décodage 5 comprend un décodeur 15 qui en recevant le signal codé SC, génère un signal audio décodé C'₁,...,C'_{M} correspondant au signal audio multi-canal C₁,...,C_{M} original.

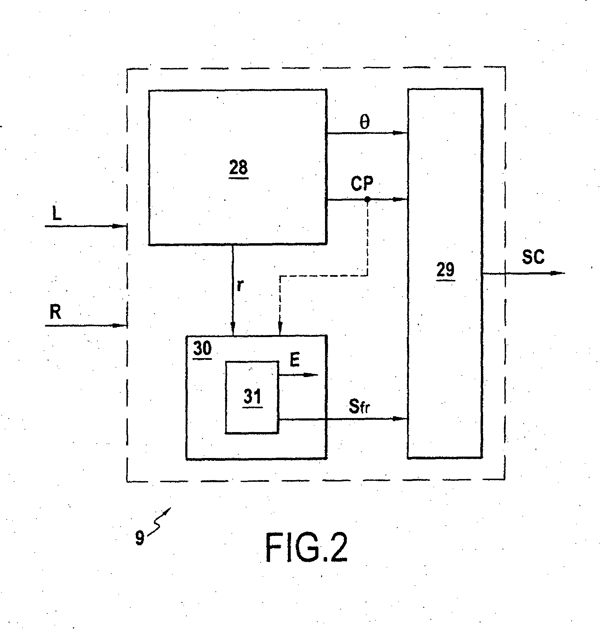

La figure 2 est une vue schématique d'un encodeur gradué 9 pour un codage gradué d'un signal audio multi-canal selon l'invention. On notera que la figure 2 est également une illustration des principales étapes du procédé de codage.

L'encodeur 9 comporte des moyens de transformation 28 par analyse en composante principale (ACP), des moyens de définition 29 et des moyens de formation 30 de structure.

Les moyens de transformation 28 par analyse en composante principale (ACP) sont destinés à transformer au moins deux canaux L et R du signal audio multi-canal en une composante principale CP et au moins une sous-composante résiduelle r par rotation défini par un paramètre de transformation ou angle de rotation θ.

Les moyens de formation 30 de structure sont destinés à former une structure résiduelle Sfᵣ par sous-bande de fréquence à partir de ladite au moins une sous-composante résiduelle r.

En outre, les moyens de définition 29 sont destinés à définir un signal audio codé SC comportant la composante principale CP, au moins une partie de la structure résiduelle Sfᵣ et ledit au moins un paramètre de transformation θ.

Ainsi, ce codage gradué permet une adaptation aux contraintes du réseau 7 de transmission. Il permet également de reconstruire un signal perceptuellement plus proche du signal original.

Les moyens de formation 30 de structure comportent des moyens d'analyse fréquentielle 31 permettant la formation d'au moins un paramètre énergétique E en fonction de ladite au moins une sous-composante résiduelle r.

En variante, les moyens d'analyse fréquentielle 31 permettent la formation d'au moins un paramètre énergétique E par une extraction de différence d'énergie par sous-bandes de fréquence entre une décomposition de la composante principale CP et la ou les sous-composantes résiduelles r. En effet, la flèche en pointillé montre que le paramètre énergétique E dépend de la composante principale et plus particulièrement d'une décomposition fréquentielle de la composante principale CP.

Par ailleurs, le ou les paramètres énergétiques E peuvent correspondre à des énergies en sous-bande de la ou les sous-composantes résiduelles r.

Ainsi, les moyens d'analyse fréquentielle 31 permettent d'appliquer une analyse fréquentielle sur au moins une sous-composante résiduelle r en fonction d'au moins un paramètre énergétique E pour former une structure résiduelle Sfᵣ par sous-bande de fréquence.

Ainsi, la structure résiduelle fine du signal audio, sur toute la bande de fréquence, est composée des structures résiduelles des sous-bandes de fréquences ainsi formées. Pour désigner la structure résiduelle d'une sous-bande de fréquence, on peut parler d'une structure résiduelle par sous-bande de fréquence ou bien d'une bande de fréquence de la structure résiduelle fine (globale).

Avantageusement, ce procédé de codage s'adapte aux capacités du réseau 7 de transmission et/ou de la qualité audio de restitution souhaité grâce à l'introduction d'une scalabilité en termes de débit de codage de la composante résiduelle ou ambiance.

Ainsi, on peut utiliser un codeur audio monophonique traditionnel (MPEG-1 Layer III ou Advanced Audio Coding par exemple) pour transmettre la composante principale tout en réalisant un codage audio flexible du signal ambiance.

Suivant le procédé de codage considéré, les paramètres énergétiques E, de transformation θ, ou de filtrage utilisés pour générer la composante d'ambiance r au décodage sont accompagnés de la structure résiduelle fine Sfᵣ de ce signal d'ambiance r.

De plus, la transmission de cette structure résiduelle Sfᵣ peut être réalisée selon différents ordres déterminés de transmissions.

A titre d'exemple, la transmission de la structure résiduelle Sfᵣ peut être réalisée selon un ordre perceptuelle des sous-bandes ou selon un critère énergétique ou selon une corrélation des composantes issues de l'ACP en sous-bandes. Cet ordonnancement peut également être une combinaison de certains de ces critères.

En effet, l'ordre de transmission de la structure résiduelle fine Sfᵣ de la composante ambiance (ou des composantes ambiances) peut être mis en place de façon à prioriser les informations à transmettre. Certaines bandes de fréquences de la structure résiduelle fine Sfᵣ peuvent être transmises en priorité. Ainsi, l'ordonnancement peut être réalisé selon des bandes de fréquence d'une enveloppe spectrale quantifiée. Cet ordonnancement peut être prédéfini selon par exemple un ordre croissant ou selon un tout autre ordre.

En outre, le procédé de codage peut comporter une analyse de corrélation entre les deux canaux L et R pour déterminer une valeur de corrélation c correspondante. Ainsi, le signal audio codé SC peut aussi comporter cette valeur de corrélation c.

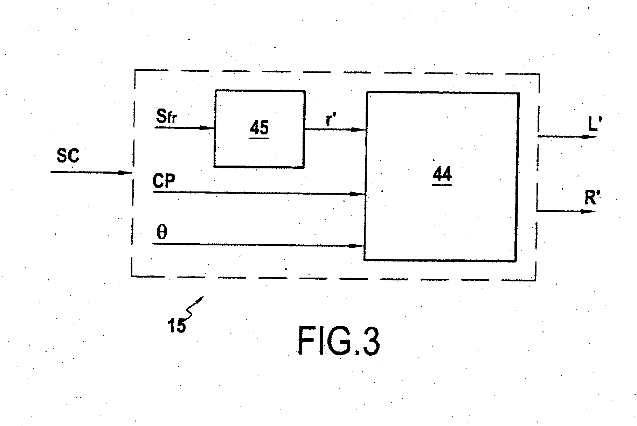

La figure 3 est une vue schématique d'un décodeur 15 pour un décodage d'un signal de réception comportant un signal audio codé SC construit selon le procédé de codage de la figure 2.

On notera que la figure 3 est également une illustration des principales étapes du procédé de décodage.

Le décodeur 15 comporte des moyens de transformation 44 par analyse en composante principale inverse (ACP⁻¹) et des moyens de synthèse fréquentielle 45.

Ainsi, à la réception d'un signal codé SC comportant une composante principale CP, au moins une partie d'une structure résiduelle Sfᵣ et au moins un paramètre de transformation θ, le décodeur 15 forme au moins deux canaux décodés L' et R' correspondant aux deux canaux L et R issus du signal audio multi-canal original.

En effet, les moyens de synthèse fréquentielle 45 permettent le décodage de la structure résiduelle Sfᵣ par sous-bande de fréquence pour synthétiser au moins une sous-composante résiduelle décodée r'.

Les moyens de transformation 44 par analyse en composante principale inverse (ACP⁻¹) forment alors les deux canaux décodés L' et R' en fonction de la sous-composante résiduelle décodée r' en plus de la composante principale CP et du paramètre de transformation θ.

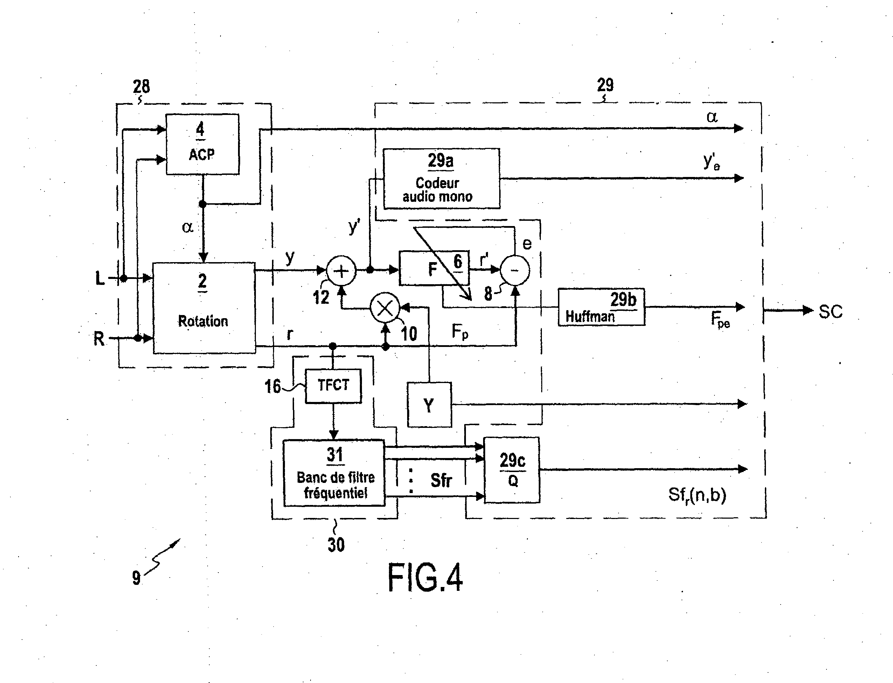

La figure 4 est une vue schématique illustrant un premier mode de réalisation d'un encodeur pour un codage gradué d'un signal audio multi-canal.

L'encodeur 9 comprend des moyens de transformation 28 par analyse en composante principale, des moyens de définition 29 et des moyens de formation 30 de structure.

Les moyens de transformation 28 par analyse en composante principale comportent des moyens de rotation 2 et des moyens ACP 4.

Les moyens de définition 29 comportent des premiers et seconds moyens de codage audio 29a et 29b et des moyens de quantification 29c.

En outre, l'encodeur 9 comprend des moyens de filtrage de prédiction 6, des moyens de soustraction 8, des moyens de multiplication 10 et des moyens d'addition 12.

Les moyens de rotation 2 génèrent une composante principale y et une sous-composante résiduelle r au moyen d'une rotation des canaux L et R selon un angle α extrait des moyens ACP 4.

Les moyens de multiplication 10 multiplient la sous-composante résiduelle r par un scalaire γ. Le scalaire y permet le mélange des signaux issus de la rotation pour faciliter la prédiction du signal r à partir du signal y.

Le résultat de la multiplication ry est ajouté par les moyens d'addition 12 à la composante principale y. Le résultat de l'addition ry+ y est appliqué aux premiers moyens de codage 29a pour générer une composante principale codée y'e.

Par ailleurs, le résultat de l'addition ry+ y est introduit dans les moyens de filtrage de prédiction 6 qui sont constitués de l'association série d'un filtre adaptatif et d'un filtre de réverbération.

Le paramètre de filtrage Fₚ à la sortie des moyens de filtrage de prédiction 6 est appliqué aux seconds moyens de codage 29b pour générer un paramètre de filtrage codée Fₚₑ.

Les moyens de formation 30 de structure permettent d'ajouter à ces informations, la structure résiduelle fine Sfᵣ de la sous-composante résiduelle r ou ambiance issue des moyens de transformation 28 par analyse en composante principale. En effet, l'utilisation des moyens de filtrage de prédiction 6 pour générer un signal Fₚ qui doit être décorrélé du signal utile à la prédiction n'est pas très adaptée. Par conséquent si le décodeur bénéficie d'informations supplémentaires, certes à un débit plus élevé, alors la composante ambiance générée permet de réaliser une ACP inverse mieux conditionnée.

Les moyens de formation 30 de structure réalisent une analyse par sous-bandes de fréquence de la sous-composante résiduelle r.

En effet, ces moyens de formation 30 de structure comportent des moyens de transformation fréquentielle 16 en plus des moyens d'analyse fréquentielle 31.

Les moyens de transformation fréquentielle 16 permettent (par exemple, par une application d'une transformée de Fourier à court terme TFCT à la sous-composante résiduelle r) de former au moins une sous-composante résiduelle fréquentielle r(b).

Ensuite, les moyens d'analyse fréquentielle 31 permettent obtenir la structure résiduelle Sfᵣ par sous-bande de fréquence, par exemple par filtrage de la sous-composante résiduelle fréquentielle au moyen d'un banc de filtre fréquentiel.

Ainsi, la structure fine Sfᵣ(n,b) pour chaque sous-bande de fréquence b et chaque portion de signal analysée n, peut être quantifiée par les moyens de quantification 29c et transmise par les moyens de transmission 11 du dispositif de codage 3 à un dispositif de décodage 5.

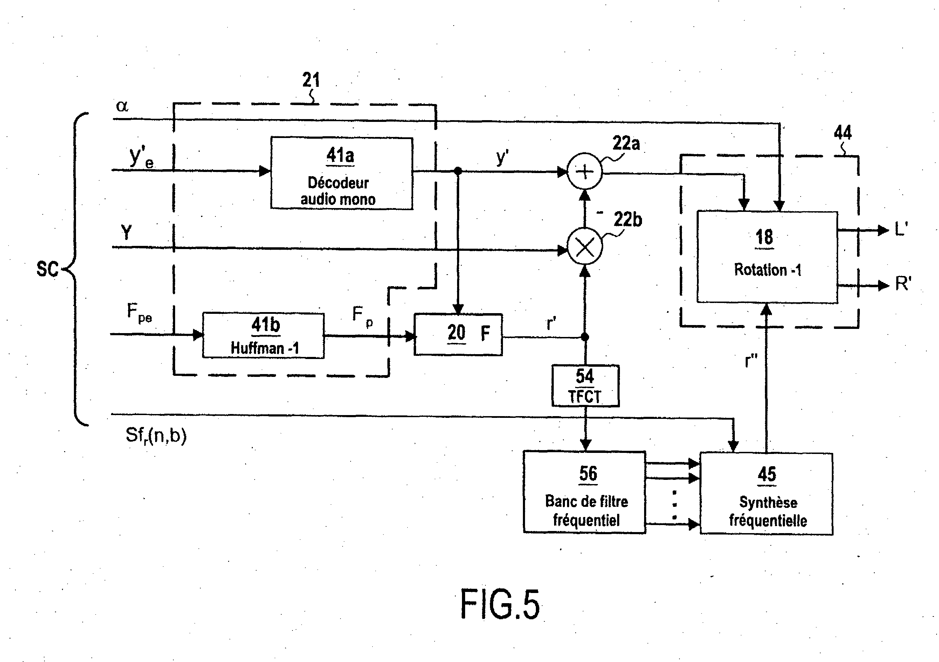

La figure 5 est une vue schématique illustrant un premier mode de réalisation d'un décodeur 15 pour un décodage d'un signal de réception comportant un signal audio codé SC construit selon le procédé de codage de la figure 4.

Le décodeur 15 comporte des moyens de synthèse fréquentielle 45 et des moyens de transformation 44 par analyse en composante principale inverse (ACP⁻¹) comprenant des moyens de rotation inverse 18.

En outre, le décodeur comprend des moyens d'extraction 21, des moyens de filtrage 20, et des moyens d'addition et de multiplication 22a et 22b. Les moyens d'extraction 21 comprennent des premiers et seconds moyens de décodage 41a et 41b.

Ainsi, grâce à la réception des coefficients du filtre adaptatif Fₚₑ, de l'angle de rotation α, du scalaire y et du signal y'ₑ, le décodeur 15 réalise alors l'opération inverse en décodant la composante principale y'ₑ par les premier moyens de décodage 41a formant une composante principale décodée y', puis en réalisant son filtrage par les moyens de filtrage 20 en une composante résiduelle filtrée r' à partir des paramètres de filtrages Fₚ issus des seconds moyens de décodage 41b.

Les moyens de multiplication 22b multiplient la composante résiduelle filtrée r' avec le scalaire y formant le produit r'y. Les moyens d'addition 22a permettent de soustraire r'y de la composante principale décodée y'.

Les moyens de rotation inverse 18 appliquent la matrice de rotation inverse en fonction de l'angle de rotation α aux signaux y' et r' pour générer les canaux L'et R' du signal stéréophonique décodé.

Si la structure résiduelle Sfᵣ(n,b) des sous-bande de fréquence de la composante r a été transmise par l'encodeur 9 alors un signal r" peut être généré par les moyens de synthèse fréquentielle 45 avant de réaliser la rotation inverse par les moyens de rotation inverse 18.

Ainsi, les deux canaux décodés L' et R' peuvent être formés par l'analyse en composante principale inverse en fonction du paramètre de transformation (ou angle de rotation) décodé, de la composante principale décodée y' et de la sous-composante résiduelle décodée r.

En outre le décodeur 15 peut comporter des moyens de transformation fréquentielle de décodage 54 et des moyens d'analyse fréquentielle de décodage 56 permettant de former des sous bandes à partir de la composante résiduelle filtrée r'.

En effet, dans le cas d'une réception partielle de la structure résiduelle Sfᵣ(n,b) (réception de quelques sous-bandes de fréquence), les moyens de synthèse fréquentielle 45 utilisent les sous-bandes issues de la synthèse r' pour compléter les sous-bandes dont la structure fine n'a pas été reçue.

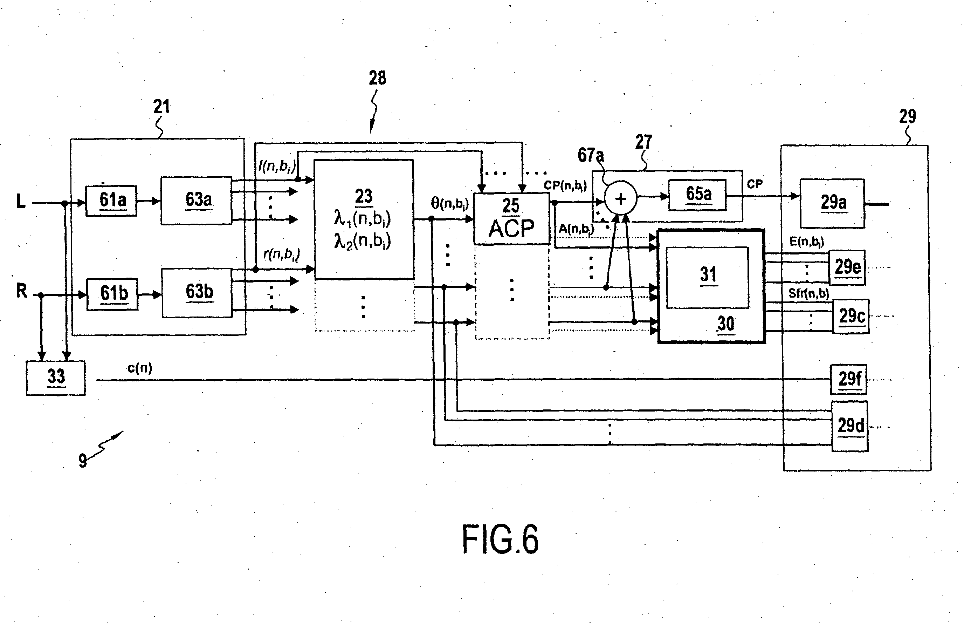

La figure 6 est une vue schématique d'un autre mode de réalisation d'un encodeur pour un codage gradué d'un signal audio multi-canal selon une transformation par analyse en composante principale (ACP) dans le domaine fréquentiel.

Selon cet exemple, l'encodeur 9 est destiné à coder un signal stéréophonique qui peut être défini par une succession de trames n, n+1, etc. et comportant deux canaux Gauche L et Droite R.

L'encodeur 9 comporte des moyens de transformation 28 par analyse en composante principale (ACP), des moyens de définition 29 et des moyens de formation 30 de structure.

Les moyens de transformation 28 par analyse en composante principale (ACP) comportent des moyens de décomposition 21, des moyens de calcul 23, des moyens ACP 25 et des moyens de combinaison 27.

Ainsi, pour une trame déterminée n, les moyens de décomposition 21 décomposent les deux canaux L et R du signal stéréophonique en une pluralité de sous-bandes fréquentielles l(n,b₁),..., l(n,b_{N}), r(n,b₁),..., r(n,b_{N}).

En effet, les moyens de décompositions 21 comportent des moyens de transformée de Fourier à court terme (TFCT) 61a et 61b et fenêtrage fréquentiel 63a et 63b permettant de regrouper les coefficients de la transformée de Fourier à court terme en sous-bandes.

Ainsi, une transformée de Fourier à court terme est appliquée à chacun des canaux L et R d'entrés. Ces canaux exprimés dans le domaine fréquentiel peuvent alors être fenêtrés en fréquence 63a et 63b selon N bandes définies suivant une échelle perceptuelle équivalente aux bandes critiques.

Les moyens de calcul 23 sont destinés à calculer au moins un paramètre de transformation θ(n,bᵢ) parmi une pluralité de paramètres de transformation θ(n,bᵢ),..., θ(n,b_{N}) en fonction d'au moins une partie de la pluralité de sous-bandes fréquentielles.

A titre d'exemple, le calcul des paramètres de transformation peut être réalisé en calculant une matrice de covariance. La matrice de covariance peut alors être calculée par les moyens de calcul 23 pour chaque trame n de signal analysée et pour chaque sous-bande de fréquence bᵢ.

Ainsi, des valeurs propres λ₁(n, bᵢ) et λ₂(n, bᵢ) du signal stéréophonique sont alors estimées pour chaque trame n et chaque sous-bande bᵢ, permettant le calcul du paramètre de transformation ou angle de rotation θ(n,bᵢ).

On notera qu'il est également possible de calculer les paramètres de transformation uniquement à partir d'une covariance des deux canaux originaux L et R.

Cet angle de rotation θ(n,bᵢ) correspond à la position de la source dominante à la trame n, pour la sous-bande bᵢ et permet alors aux moyens de rotation ou de transformation 25 de réaliser une rotation des données par sous-bande de fréquence pour déterminer une composante principale fréquentielle CP(n, bᵢ) et une composante résiduelle (ou d'ambiance) fréquentielle A(n, bᵢ). Les énergies des composantes CP(n, bᵢ) et A(n, bᵢ) sont proportionnelles aux valeurs propres λ₁ et λ₂ telles que: λ₁ > λ₂. Par conséquent, le signal A(b) a une énergie beaucoup plus faible que celle du signal CP(b).

Les moyens de combinaison 27 combinent les sous-composantes principales fréquentielles CP(n, b₁),..., CP(n, b_{N}) pour former une unique composante principale CP(n).

En effet, ces moyens de combinaison 27 comportent des moyens de TFCT inverse 65a et des moyens d'addition 67a. La somme par les moyens d'addition 67a de ces composantes fréquentielle à bande limitée CP(n, bᵢ) permet alors d'obtenir la composante principale CP(n) pleine bande dans le domaine fréquentiel. La TFCT inverse de la composante CP(n) résulte une composante temporelle pleine bande.

Les moyens de formation 30 de structure comprenant des moyens d'analyse fréquentielle 31 permettent de former au moins un paramètre énergétique E(n,bᵢ) parmi un ensemble de paramètres énergétiques E(n,b₁),..., E(n,b_{N}) en fonction des sous-composantes résiduelles fréquentielles A(n,b₁),..., A(n,b_{N}) et/ou sous-composantes principales fréquentielles CP(n,b₁),..., CP(n,b_{N}).

Selon un premier mode de réalisation, les paramètres énergétiques E(n,b₁),..., E(n,b_{N}) sont formés par une extraction des différences d'énergie par sous-bandes de fréquence entre les sous-composantes principales fréquentielles CP(n,b₁),..., CP(n,b_{N}) et les sous-composantes résiduelles fréquentielles A(n,b₁),..., A(n,b_{N}).

Selon un autre mode de réalisation, les paramètres énergétiques E(n,b₁),..., E(n,b_{N}) correspondent directement à l'énergie par sous-bandes de fréquence des sous-composantes résiduelles fréquentielles A(n,b₁),..., A(n,b_{N}).

Par conséquent, afin de mieux synthétiser l'ambiance sonore, le signal audio codé SC peut avantageusement comporter au moins un paramètre énergétique parmi l'ensemble de paramètres énergétiques E(n,b₁),..., E(n,b_{N}).

En outre, les moyens de formation 30 de structure permettent d'appliquer une analyse fréquentielle sur au moins une sous-composante résiduelle A(n,bᵢ) en fonction d'au moins un paramètre énergétique E(n,bᵢ) pour former la structure résiduelle Sfᵣ(n,bᵢ) par sous-bande de fréquence.

Ainsi, si les possibilités du réseau 7 de transmission le permettent ou si une qualité audio supérieure est attendue, le ou les paramètres énergétiques E(n,b₁),..., E(n,b_{N}) peuvent être accompagnés d'au moins une partie de la structure fine par sous-bande de la composante résiduelle A(n,bᵢ) du signal Sfᵣ(n,bᵢ).

Cette approche graduée du codage de la composante résiduelle A(n,bᵢ) offre la possibilité de transmettre des informations supplémentaires de manière à s'approcher d'une reconstruction asymptotiquement parfaite du signal stéréophonique original. En effet, moyennant un débit plus élevé, le signal stéréophonique reconstruit sera perceptuellement plus proche du signal stéréophonique original.

En outre, l'encodeur 9 peut comporter des moyens d'analyse de corrélation 33 pour réaliser une analyse de corrélation temporelle entre les deux canaux L et R afin de déterminer un indice ou une valeur de corrélation c(n) correspondante. Ainsi, le signal audio codé SC peut avantageusement comporter cette valeur de corrélation c(n) pour indiquer une éventuelle présence de réverbération dans le signal original.

Les moyens de définition 29 peuvent comporter un moyen de codage audio 29a pour coder la composante principale CP et des moyens de quantifications 29c, 29d, 29e et 29f pour quantifier au moins une partie de la structure résiduelle Sfᵣ(n,bᵢ), le ou les paramètres de transformation θ(n,bᵢ), au moins une partie de la structure résiduelle Sfᵣ(n,bᵢ), le ou les paramètres énergétiques E(n,bᵢ) et la valeur de corrélation c(n) respectivement.

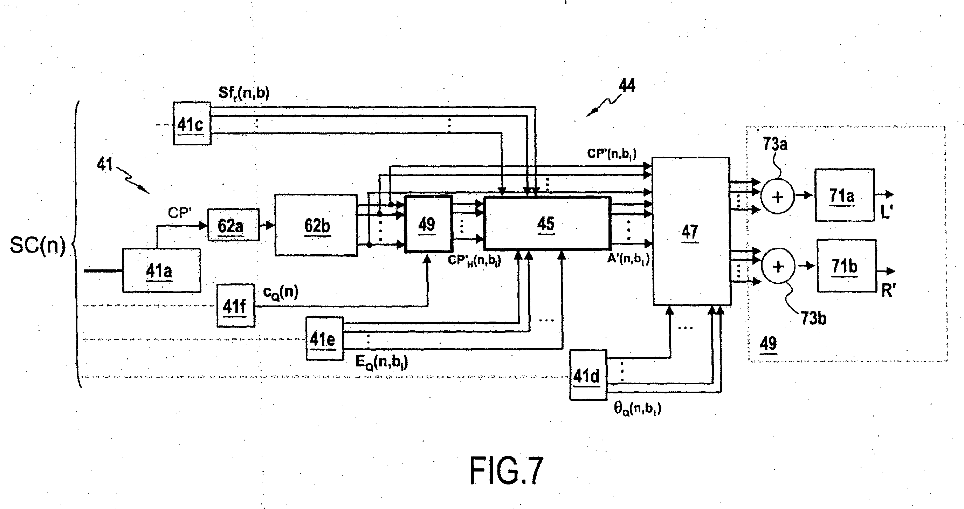

La figure 7 est une vue schématique d'un décodeur 15 pour décoder un signal audio codé SC(n) comprenant un flux audio et des paramètres de décodage en un signal stéréophonique basé sur une ACP inverse par sous-bandes de fréquence.

Le décodeur 15 comporte des moyens de transformation 44 par analyse en composante principale inverse (ACP⁻¹) et des moyens de synthèse fréquentielle 45.

Les moyens de transformation 44 par analyse en composante principale inverse (ACP⁻¹) comportent des moyens d'extraction 41, des moyens de décomposition de décodage 43, des moyens de transformation inverse 47, et des moyens de combinaison de décodage 49.

Ainsi, à la réception du signal audio codé SC(n), les moyens d'extraction 41 comportent des moyens de décodage monophonique 41a pour extraire la composante principale décodée CP' et des moyens de déquantification 41c, 41d, 41e et 41f pour extraire la structure résiduelle Sf_{rQ}(n,bᵢ), les paramètres de transformation ou angles de rotation θ_{Q}(n,bᵢ), les paramètres d'énergie E_{Q}(n,bᵢ), et la valeur de corrélation C_{Q}(n).

Les moyens de décomposition de décodage 43 comprenant par exemple des TFCT 62a et des bancs de filtre 62b décomposent la composante principale décodée CP' par un fenêtrage fréquentiel à N bandes, en des sous-composantes principales fréquentielles décodées.

En outre, une composante résiduelle A'(n, bᵢ) peut être synthétisée par les moyens de synthèse fréquentielle 45 à partir du flux audio décodé CP'(n, bᵢ), mis en forme spectralement par les paramètres d'énergie E_{Q}(n,bᵢ) déquantifiés et éventuellement par la structure résiduelle Sf_{rQ}(n,bᵢ).

En effet, les informations supplémentaires transmises par l'encodeur 9 peuvent être utilisées ou non par le décodeur 15. Ainsi, la structure fine résiduelle Sfᵣ(n,bᵢ), de la composante résiduelle A(n,bᵢ) par sous-bande de fréquence peut donc être utilisée lors de la synthèse fréquentielle du signal A'(n, bᵢ) à partir du signal CP' décodé et éventuellement filtré.

La synthèse fréquentielle du signal A'(n, bᵢ) dispose alors des paramètres énergétiques E_{Q}(n,bᵢ) et éventuellement de la structure fine Sf_{rQ}(n,bᵢ) de la composante résiduelle déquantifiée.

Le décodeur 15 réalise alors l'opération inverse du codeur puisque l'ACP est une transformation linéaire. L'ACP inverse est réalisée par les moyens de transformation inverse, en multipliant les signaux CP_{H}'(n, bᵢ) et A'(n, bᵢ) par la matrice transposée de la matrice de rotation utilisée à l'encodage. Cela est rendu possible grâce à la quantification inverse des angles de rotation par sous-bande de fréquence.

On notera que les signaux CP'_{H}(n, bᵢ) correspondent aux composantes principales CP'(n, bᵢ) décorellées par des moyens de filtrage 49 de décorrélation ou de réverbération.

En effet, dues aux propriétés de décorrélation de l'ACP, l'utilisation d'un filtre de décorrélation ou de réverbération est souhaitable pour synthétiser une composante CP'_{H}(n, bᵢ) décorrélée du signal CP'(n, bᵢ) et par suite du signal A'(n, bᵢ).

Les moyens de filtrage 49 comportent un filtre dont la réponse impulsionnelle h(n) est fonction des caractéristiques du signal original. En effet, l'analyse temporelle de la corrélation du signal original à la trame n détermine la valeur de corrélation c(n) qui correspond au choix du filtre à utiliser au décodage. Par défaut, c(n) impose la réponse impulsionnelle d'un filtre passe-tout à phase aléatoire qui réduit fortement l'intercorrélation des signaux CP'(n, bᵢ) et CP'_{H}(n, bᵢ). Si l'analyse temporelle du signal stéréo révèle la présence de réverbération, c(n) impose l'utilisation, par exemple, d'un bruit blanc gaussien d'énergie décroissante de manière à réverbérer le contenu du signal CP'(n, bᵢ).

Les moyens de combinaison 49 comportant des moyens de TFCT inverses 71a et 71b et des moyens d'addition 73a et 73b, combinent les sous-bandes fréquentielles décodées pour former deux composantes décodées L'et R'.

Cette approche graduée du codage de la composante résiduelle A(n, bᵢ) offre la possibilité de transmettre des informations supplémentaires de manière à s'approcher d'une reconstruction très proche du signal stéréophonique original.

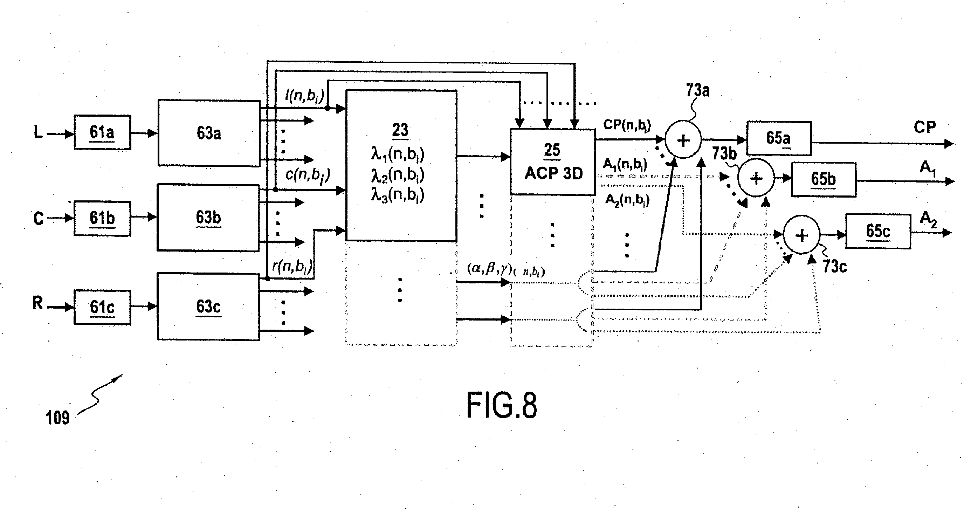

La figure 8 illustre un encodeur 109 d'un signal multi-canal appliquant l'ACP à trois canaux. En effet, cet encodeur utilise une ACP tridimensionnelle du signal à trois canaux paramétrés par les angles d'Euler (α,β,γ)_{b} estimés pour chaque sous-bande b.

L'encodeur 109 se distingue de celui de la figure 7 par le fait qu'il comporte trois moyens de transformée de Fourier à court (TFCT) 61a, 61b et 61c ainsi que trois modules de fenêtrage fréquentiel 63a, 63b et 63c.

En outre, il comporte trois moyens de TFCT inverses 65a, 65b et 65c ainsi que trois moyens d'addition 73a, 73b et 73c.

L'ACP est alors appliquée à un triplet de signaux L, C et R. L'ACP tridimensionnelle 3D est alors réalisée par une rotation 3D des données paramétrée par les angles d'Euler (α,β,γ). Comme pour le cas stéréophonique, ces angles de rotations sont estimés pour chaque sous-bande de fréquence à partir de la covariance et des valeurs propres du signal multi-canal original.

Le signal CP contient la somme des sources sonores dominantes et la partie des composantes d'ambiance qui coïncide spatialement avec ces sources présentes dans les signaux originaux.

La somme des sources sonores secondaires, qui se recouvrent spectralement avec les sources dominantes, et des autres composantes d'ambiances se répartie proportionnellement aux valeurs propres λ₂ et λ₃ dans les signaux A₁ et A₂ qui sont nettement moins énergétiques que le signal CP puisque : λ₁ > λ₂ > λ₃.

Ainsi, le procédé de codage appliqué aux signaux stéréophoniques peut être étendu au cas des signaux multi-canal C₁,...,C₆ de format 5.1 comportant les canaux suivants : Gauche (Left) L, Central (Center) C, Droit (Right) R, Arrière Gauche (Left surround) Ls, Arrière Droit (Right surround) Rs, et Basse Fréquences (Low Frequency Effect) LFE.

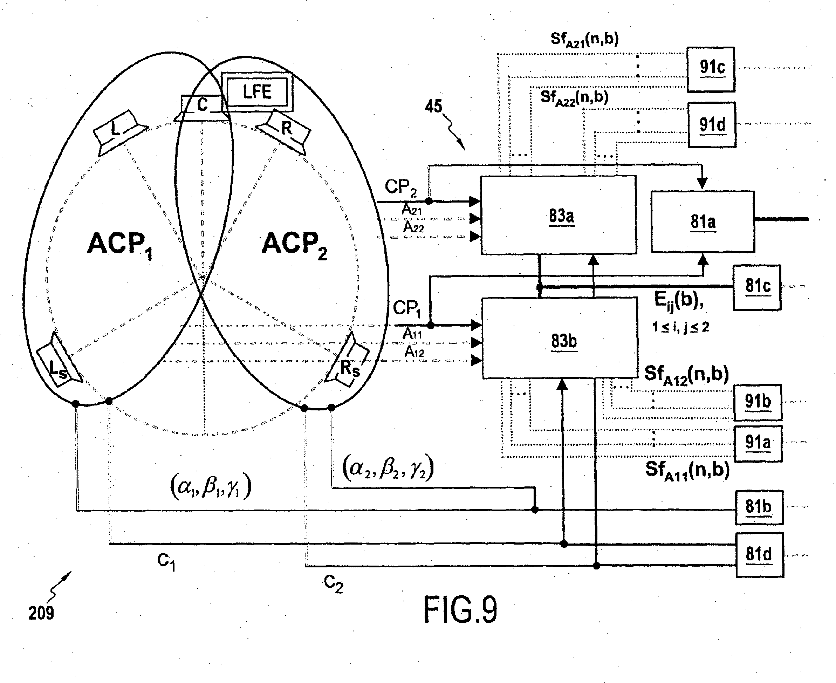

En effet, la figure 9 est une vue schématique illustrant un encodeur 209 d'un signal multi-canal de format 5.1. Selon cet exemple, le codage audio paramétrique des signaux 5.1 est basé sur deux ACP tridimensionnelles des signaux séparés selon le plan médian.

Ainsi, cet encodeur 209 permet de réaliser une première ACP₁, du triplet 80a de signaux (L, C, Lₛ) selon l'encodeur 109 de la figure 12 et de même, une seconde ACP₂ du triplet 80b de signaux (R, C, Rₛ) selon l'encodeur 109.

Ainsi, le couple de composantes principales (CP₁, CP₂) peut être considéré comme un signal stéréophonique (L, R) spatialement cohérent avec le signal multi-canal original.

Il convient de préciser que le signal LFE peut être codé indépendamment des autres signaux puisque le contenu basse-fréquence à caractère discret de ce canal n'est que peu sensible à la réduction des redondances inter-canal.

L'encodage s'adapte aux contraintes de débit du réseau de transmission en transmettant un signal stéréophonique codé par un codeur audio stéréophonique 81a accompagné de paramètres quantifiés par des moyens de quantifications 81a à 81d, ainsi que des moyens de quantifications 91a à 91d définis pour chaque trame n et chaque sous-bande bᵢ de fréquence.

Ainsi, le codeur audio stéréophonique 81a permet de coder le couple de composantes principales (CP₁, CP₂). Les moyens de quantifications 81b permettent de quantifier les angles d'Euler (α, β, γ) utiles aux ACP de chaque triplet de signaux.

Les moyens de quantifications 81d permettent de quantifier les valeurs c₁(n) et c₂(n) déterminant le choix du filtre à utiliser pour chaque triplet de signaux.

En outre, des moyens de synthèse fréquentielle 45 comportant des moyens de filtrage et d'analyse fréquentielle 83a et 83b permettent de déterminer des paramètres ou différences d'énergies par sous-bande de fréquence Eᵢⱼ(n,b) (1 ≤ i,j ≤ 2) entre les signaux CP₁ et A₁₁, A₁₂ ainsi que les signaux CP₂ et A₂₁, A₂₂ respectivement.

En variante, les paramètres d'énergie peuvent correspondre aux énergies par sous-bande des signaux A₁₁, A₁₂ et A₂₁, A₂₂.

Les paramètres d'énergie Eᵢⱼ(n,b) peuvent alors être quantifiés par les moyens de quantifications 81c.

En outre, les structures résiduelle fines Sf_{Aij}(n,b) avec 1 ≤ i,j ≤ 2, des quatre signaux résiduels ou d'ambiances A₁₁, A₁₂ et A₂₁, A₂₂ issus des ACP 3D peuvent être quantifiées par les moyens de quantifications 91a à 91d.

Comme pour le codage des signaux stéréophoniques, au moins une partie des structures fines Sf_{Aij}(n,b) des signaux résiduelles A₁₁, A₁₂ et A₂₁, A₂₂.peuvent être transmises comme informations supplémentaires moyennant un débit plus élevé et par conséquent une qualité de reconstruction audio supérieure.

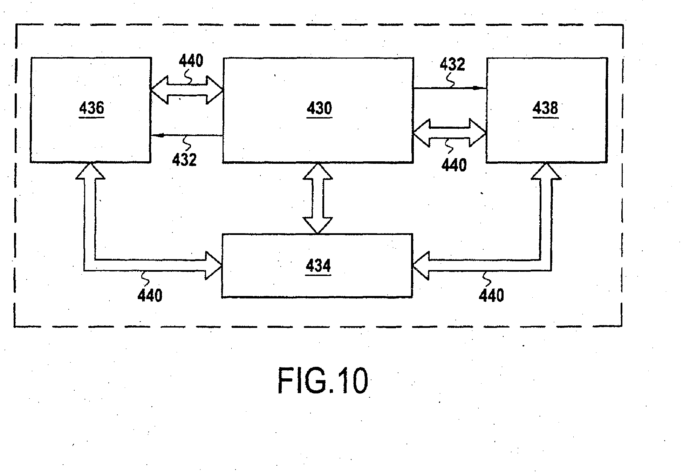

La figure 10 illustre très schématiquement un système informatique mettant en ouvre l'encodeur ou le décodeur selon les figures 1 à 19. Ce système informatique comporte de manière classique une unité centrale de traitement 430 commandant par des signaux 432 une mémoire 434, une unité d'entrée 436 et une unité de sortie 438. Tous les éléments sont raccordés entre eux par des bus de données 440.

De plus, ce système informatique peut être utilisé pour exécuter un programme d'ordinateur comportant des instructions de codes de programme pour la mise en oeuvre du procédé de codage ou de décodage selon l'invention.

En effet, l'invention vise aussi un produit programme d'ordinateur téléchargeable depuis un réseau de communication comprenant des instructions de codes de programme pour l'exécution des étapes du procédé de codage ou de décodage selon l'invention lorsqu'il est exécuté sur un ordinateur. Ce programme d'ordinateur peut être stocké sur un support lisible par ordinateur et peut être exécutable par un microprocesseur.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions d'un programme d'ordinateur tel que mentionné ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé en question.

Ainsi, l'invention permet un codage audio gradué en débit. Ceci offre la possibilité de s'approcher d'une reconstruction asymptotiquement parfaite des signaux originaux. En effet, moyennant un débit plus élevé, le signal reconstruit sera perceptuellement plus proche du signal original.

En outre le procédé selon l'invention, est gradué en nombre de canaux décodés. Par exemple, le codage d'un signal au format 5.1 permet également le décodage en un signal stéréophonique de façon à assurer la compatibilité avec différents systèmes de restitution.

Les domaines d'application de la présente invention, sont les transmissions audio-numériques sur divers réseaux de transmission à différents débits puisque la méthode proposée permet d'adapter le débit de codage en fonction du réseau ou de la qualité souhaité.

De plus, ce procédé est généralisable au codage audio multi-canal avec un nombre de signaux plus grand. En effet, la méthode proposée est par nature généralisable et applicable à de nombreux formats audio 2D et 3D (formats 6.1, 7.1, ambisonique, wave field synthesis, etc.).

Un exemple d'application particulier est la compression, transmission puis restitution d'un signal audio multi-canal sur internet suite à la demande/achat d'un internaute (auditeur). Ce service est d'ailleurs couramment appelé "audio on demand". La méthode proposée permet alors d'encoder un signal multi-canal (stéréophonique ou de type 5.1) à un débit supporté par le réseau internet reliant l'auditeur au serveur. Ainsi, l'auditeur peut écouter la scène sonore décodée au format souhaité sur son système de diffusion multi-canal. Dans le cas où le signal à transmettre est de type 5.1 mais que l'utilisateur ne possède pas de système de restitution multi-canal, la transmission peut alors se limiter aux composantes principales du signal multi-canal de départ ; et par suite, le décodeur délivre un signal avec moins de canaux comme un signal stéréophonique par exemple.

## Revendications

1. Procédé de codage scalable d'un signal audio multi-canal, comprenant une transformation par analyse en composante principale (ACP) d'au moins deux canaux (L, R) dudit signal audio en une composante principale (CP) et au moins une sous-composante résiduelle par rotation défini par un paramètre de transformation (θ(n,bᵢ)), **caractérisé en ce que** ladite au moins une sous-composante résiduelle est une sous-composante résiduelle fréquentielle (A(n,bᵢ)) réalisée selon une analyse en composante principale dans le domaine fréquentiel, et **en ce que** le procédé comporte les étapes suivantes :
- formation d'une structure résiduelle (Sfᵣ(n,b)) par sous-bande de fréquence par filtrage par un banc de filtre de ladite au moins une sous-composante résiduelle fréquentielle, et
- définition d'un signal audio codé comportant ladite composante principale (CP), la structure résiduelle (Sfᵣ(n,b)) d'au moins une sous bande de fréquence selon un ordre de transmission déterminé des structures résiduelles des sous-bandes de fréquence et ledit paramètre de transformation (θ(n,bᵢ)).

2. Procédé selon la revendication 1, **caractérisé en ce qu'**il comporte une formation d'au moins un paramètre énergétique en fonction de ladite au moins une sous-composante résiduelle fréquentielle.

3. Procédé selon la revendication 2, **caractérisé en ce que** ledit au moins un paramètre énergétique est formé par une extraction de différence d'énergie par sous-bandes de fréquence entre une décomposition de ladite composante principale (CP) et ladite au moins une sous-composante résiduelle fréquentielle.

4. Procédé selon la revendication 2, **caractérisé en ce que** ledit au moins un paramètre énergétique correspond à une énergie en sous-bande de ladite au moins sous-composante résiduelle fréquentielle.

5. Procédé selon la revendication 1, **caractérisé en ce que** la transformation par analyse en composante principale (ACP) dans le domaine fréquentiel comporte les étapes suivantes :
- décomposer lesdits au moins deux canaux (L, R) dudit signal audio en une pluralité de sous-bandes fréquentielles,
- calculer ledit au moins un paramètre de transformation (θ(n,bᵢ)) en fonction d'au moins une partie de ladite pluralité de sous-bandes fréquentielles,
- transformer au moins une partie de ladite pluralité de sous-bandes fréquentielles en ledit au moins une sous-composante résiduelle fréquentielle et au moins une sous-composante principale fréquentielle en fonction dudit au moins un paramètre de transformation, et
- former ladite composante principale à partir de ladite au moins une sous-composante principale fréquentielle.

6. Procédé selon la revendication 5, **caractérisé en ce que** ladite pluralité de sous-bandes fréquentielles est définie suivant une échelle perceptuelle.

7. Procédé de codage scalable d'un signal audio multi-canal, comprenant une transformation par analyse en composante principale (ACP) d'au moins deux canaux (L, R) dudit signal audio en une composante principale et au moins une sous-composante résiduelle (r) par rotation défini par un paramètre de transformation (α), **caractérisé en ce qu'**il comporte les étapes suivantes :
- application d'une transformée de Fourier à court terme (TFCT) à ladite au moins une sous-composante résiduelle (r) pour former au moins une sous-composante résiduelle fréquentielle,
- filtrage de ladite au moins une sous-composante résiduelle fréquentielle par un banc de filtre fréquentiel pour obtenir des structures résiduelles (Sfᵣ) des sous-bandes de fréquence, et
- définition d'un signal audio codé (SC) comportant ladite composante principale, la structure résiduelle (Sfᵣ) d'au moins une sous bande de fréquence selon un ordre de transmission déterminé des structures résiduelles des sous-bandes de fréquence et ledit paramètre de transformation (α).

8. Procédé selon l'une quelconque des revendications 1 ou 7, **caractérisé en ce que** ledit ordre de transmission déterminé est réalisé selon un ordre perceptuel des sous-bandes ou un critère énergétique ou selon une corrélation des composantes issues de l'analyse en composante principale en sous-bandes.

9. Procédé selon l'une quelconque des revendications 1 à 8, **caractérisé en ce qu'**il comporte une analyse de corrélation entre lesdits au moins deux canaux (L, R) pour déterminer une valeur de corrélation correspondante, et **en ce que** ledit signal audio codé comporte en outre ladite valeur de corrélation.

10. Procédé de décodage d'un signal de réception comportant un signal audio codé construit selon l'une quelconque des revendications 1 à 6, **caractérisé en ce qu'**il comporte les étapes suivantes :
- recevoir le signal audio codé (SC(n)),
- extraire une composante principale décodée (CP') et au moins un paramètre de transformation décodé,
- décoder au moins une structure résiduelle (Sfᵣ(n,b)) d'une sous-bande de fréquence pour synthétiser au moins une sous-composante résiduelle décodée (A'(n,bᵢ)).
- décomposer ladite composante principale décodée (CP') en au moins une sous-composante principale fréquentielle décodée,
- transformer par analyse en composante principale inverse ladite au moins une sous-composante principale décodée et ladite au moins une sous-composante résiduelle décodée (A'(n,b)) en des sous-bandes fréquentielles décodées, et
- combiner lesdites sous-bandes fréquentielles décodées pour former au moins deux canaux décodés (L', R') correspondant auxdits au moins deux canaux (L, R) issus dudit signal audio multi-canal original.

11. Procédé de décodage d'un signal de réception comportant un signal audio codé construit selon l'une quelconque des revendications 7 à 9, **caractérisé en ce qu'**il comporte les étapes suivantes :
- recevoir le signal audio codé (SC),
- extraire une composante principale décodée (y') et au moins un paramètre de transformation décodé,
- décoder au moins une structure résiduelle d'une sous-bande de fréquence pour synthétiser au moins une sous-composante résiduelle décodée (r').
- former au moins deux canaux décodés (L', R') correspondant auxdits au moins deux canaux (L, R) issus dudit signal audio multi-canal original, par analyse en composante principale inverse en fonction dudit au moins un paramètre de transformation décodé, de ladite composante principale décodée (y') et de ladite au moins une sous-composante résiduelle décodée (r').

12. Encodeur scalable d'un signal audio multi-canal, comprenant des moyens de transformation (28) par analyse en composante principale (ACP) pour transformer au moins deux canaux (L, R) dudit signal audio en une composante principale (CP) et au moins une sous-composante résiduelle par rotation défini par un paramètre de transformation θ(n,bᵢ), **caractérisé en ce que** les moyens de transformation par analyse en composante principale sont dans le domaine fréquentiel pour obtenir au moins une sous-composante résiduelle fréquentielle (A(n,bᵢ)) et **en ce qu'**il comporte:
- des moyens de formation (30) de structure pour former une structure résiduelle (Sfᵣ(n,b)) par sous-bande de fréquence par des moyens filtrage comportant un banc de filtre (31) pour filtrer ladite au moins une sous-composante résiduelle fréquentielle, et
- des moyens de définition (29) pour définir un signal audio codé comportant ladite composante principale (CP), au moins la structure résiduelle (Sfᵣ(n,b)) d'au moins une sous-bande de fréquence selon un ordre de transmission déterminé des structures résiduelles des sous-bandes de fréquence et ledit paramètre de transformation (θ(n,bᵢ)).

13. Encodeur scalable d'un signal audio multi-canal, comprenant des moyens de transformation (28) par analyse en composante principale (ACP) pour transformer au moins deux canaux (L, R) dudit signal audio en une composante principale et au moins une sous-composante résiduelle (r) par rotation défini par un paramètre de transformation (α), **caractérisé en ce qu'**il comporte:
- des moyens de transformation (16) pour appliquer une transformée de Fourier à court terme (TFCT) à ladite au moins une sous-composante résiduelle (r) pour former au moins une sous-composante résiduelle fréquentielle,
- des moyens de filtrage comportant un banc de filtre fréquentiel (31) pour filtrer ladite au moins une sous-composante résiduelle fréquentielle pour obtenir des structures résiduelles (Sfᵣ) des sous-bandes de fréquence, et
- des moyens de définition (29) pour définir un signal audio codé (SC) comportant ladite composante principale, au moins la structure résiduelle (Sfᵣ) d'au moins une sous-bande de fréquence selon un ordre de transmission déterminé des structures résiduelles des sous-bandes de fréquence et ledit paramètre de transformation (α).

14. Décodeur scalable d'un signal de réception comportant un signal audio codé construit selon l'une quelconque des revedications 1 à 6, **caractérisé en ce qu'**il comporte :
- des moyens de réception d'un signal audio codé (SC(n)),
- des moyens d'extraction d'une composante principale décodée (CP') et
d'au moins un paramètre de transformation décodé,
- des moyens de synthèse fréquentielle 45 pour décoder au moins une structure résiduelle (Sfᵣ(n,b)) d'une sous-bande de fréquence pour synthétiser au moins une sous-composante résiduelle décodée (A'(n,bᵢ)),
- des moyens de décomposition de ladite composante principale décodée (CP') en au moins une sous-composante principale fréquentielle décodée,
- des moyens de transformation par analyse en composante principale inverse pour transformer ladite au moins une sous-composante principale décodée et ladite au moins une sous-composante résiduelle décodée (A'(n,b)) en des sous-bandes fréquentielles décodées, et
- des moyens de combinaison desdites sous-bandes fréquentielles décodées pour former au moins deux canaux décodés (L', R') correspondant auxdits au moins deux canaux (L, R) issus dudit signal audio multi-canal original.

15. Décodeur scalable d'un signal de réception comportant un signal audio codé construit selon l'une quelconque des revendications 7 à 9, **caractérisé en ce qu'**il comporte :
- des moyens de réception d'un signal audio codé (SC),
- des moyens d'extraction d'une composante principale décodée (y') et d'au moins un paramètre de transformation décodé,
- des moyens de synthèse fréquentielle 45 pour décoder au moins une structure résiduelle d'une sous-bande de fréquence pour synthétiser au moins une sous-composante résiduelle décodée (r'').
- des moyens de formation d'au moins deux canaux décodés (L', R') correspondant auxdits au moins deux canaux (L, R) issus dudit signal audio multi-canal original, par analyse en composante principale inverse en fonction dudit au moins un paramètre de transformation décodé, de ladite composante principale décodée (y') et de ladite au moins sous-composante résiduelle décodée (r').

16. Programme d'ordinateur téléchargeable depuis un réseau de communication et/ou stocké sur un support lisible par ordinateur et/ou exécutable par un microprocesseur, **caractérisé en ce qu'**il comprend des instructions de codes de programme pour l'exécution des étapes du procédé de codage selon au moins l'une des revendications 1 à 9, lorsqu'il est exécuté sur un ordinateur ou un microprocesseur.

17. Programme d'ordinateur téléchargeable depuis un réseau de communication et/ou stocké sur un support lisible par ordinateur et/ou exécutable par un microprocesseur, **caractérisé en ce qu'**il comprend des instructions de codes de programme pour l'exécution des étapes du procédé de décodage selon au moins l'une des revendications 10 à 11, lorsqu'il est exécuté sur un ordinateur ou un microprocesseur.

## Patentansprüche

1. Verfahren zur skalierbaren Codierung eines mehrkanaligen Audiosignals, umfassend eine Umwandlung durch Hauptkomponentenanalyse (ACP) mindestens zweier Kanäle (L, R) des Audiosignals in eine Hauptkomponente (CP) und mindestens eine Restunterkomponente durch durch einen Umwandlungsparameter (θ(n,bᵢ)) definierte Rotation, **dadurch gekennzeichnet, dass** die mindestens eine Restunterkomponente eine Frequenzrestunterkomponente (A(n,bᵢ)) ist, die nach einer Hauptkomponentenanalyse im Frequenzbereich erstellt wird, und dass das Verfahren die folgenden Schritte umfasst:
- Bildung einer Reststruktur (Sfᵣ(n,b)) pro Frequenzunterband durch Filtern der mindestens einen Frequenzrestunterkomponente durch eine Filterbank, und
- Definition eines codierten Audiosignals, umfassend die Hauptkomponente (CP), die Reststruktur (Sfᵣ(n,b)) mindestens eines Frequenzunterbandes in einer bestimmten Übertragungsreihenfolge der Reststrukturen der Frequenzunterbänder und den Umwandlungsparameter (θ(n,bᵢ)).

2. Verfahren nach Anspruch 1, **dadurch gekennzeichnet, dass** es eine Bildung mindestens eines energetischen Parameters in Abhängigkeit von der mindestens einen Frequenzrestunterkomponente umfasst.

3. Verfahren nach Anspruch 2, **dadurch gekennzeichnet, dass** der mindestens eine energetische Parameter durch eine Energiedifferenzextraktion pro Frequenzunterbänder zwischen einer Zerlegung der Hauptkomponente (CP) und der mindestens einen Frequenzrestunterkomponente gebildet ist.

4. Verfahren nach Anspruch 2, **dadurch gekennzeichnet, dass** der mindestens eine energetische Parameter einer Energie im Unterband der mindestens einen Frequenzrestunterkomponente entspricht.

5. Verfahren nach Anspruch 1, **dadurch gekennzeichnet, dass** die Umwandlung durch Hauptkomponentenanalyse (ACP) in dem Frequenzbereich die folgenden Schritte umfasst:
- Zerlegung der mindestens zwei Kanäle (L, R) des Audiosignals in eine Vielzahl von Frequenzunterbändern,
- Berechnung des mindestens einen Umwandlungsparameters (θ(n,bᵢ)) in Abhängigkeit von mindestens einem Teil der Vielzahl von Frequenzunterbändern,
- Umwandlung mindestens eines Teils der Vielzahl von Frequenzunterbändern in die mindestens eine Frequenzrestunterkomponente und mindestens eine Frequenzhauptunterkomponente in Abhängigkeit von dem mindestens einen Umwandlungsparameter, und
- Bildung der Hauptkomponente aus der mindestens einen Frequenzhauptunterkomponente.

6. Verfahren nach Anspruch 5, **dadurch gekennzeichnet, dass** die Vielzahl von Frequenzunterbändern nach einer Wahrnehmungsskala definiert wird.

7. Verfahren zur skalierbaren Codierung eines mehrkanaligen Audiosignals, umfassend eine Umwandlung durch Hauptkomponentenanalyse (ACP) von mindestens zwei Kanälen (L, R) des Audiosignals in eine Hauptkomponente und mindestens eine Restunterkomponente (r) durch durch einen Umwandlungsparameter (α) definierte Rotation, **dadurch gekennzeichnet, dass** es die folgenden Schritte umfasst:
- Anlegen einer Kurzzeit-Fourier-Transformation (TFCT) an die mindestens eine Restunterkomponente (r), um mindestens eine Frequenzrestunterkomponente zu bilden,
- Filterung der mindestens einen Frequenzrestunterkomponente durch eine Frequenzfilterbank, um Reststrukturen (Sfᵣ) der Frequenzunterbänder zu erhalten, und
- Definition eines codierten Audiosignals (SC), umfassend die Hauptkomponente, die Reststruktur (Sfᵣ) mindestens eines Frequenzunterbandes in einer bestimmten Übertragungsreihenfolge der Reststrukturen der Frequenzunterbänder und den Umwandlungsparameter (α).

8. Verfahren nach einem der Ansprüche 1 oder 7, **dadurch gekennzeichnet, dass** die bestimmte Übertragungsreihenfolge nach einer Wahrnehmungsreihenfolge der Unterbänder oder einem energetischen Kriterium oder nach einer Korrelation der Komponenten, die aus der Unterband-Hauptkomponentenanalyse hervorgehen, bestimmt wird.

9. Verfahren nach einem der Ansprüche 1 bis 8, **dadurch gekennzeichnet, dass** es eine Korrelationsanalyse zwischen den mindestens zwei Kanälen (L, R) umfasst, um einen entsprechenden Korrelationswert zu bestimmen, und dass das codierte Audiosignal ferner den Korrelationswert umfasst.

10. Verfahren zur Decodierung eines Empfangssignals, umfassend ein codiertes Audiosignal, das nach einem der Ansprüche 1 bis 6 aufgebaut ist, **dadurch gekennzeichnet, dass** es die folgenden Schritte umfasst:
- Empfang des codierten Audiosignals (SC(n)),
- Extraktion einer decodierten Hauptkomponente (CP') und mindestens eines decodierten Umwandlungsparameters,
- Decodierung mindestens einer Reststruktur (Sfᵣ(n,b)) eines Frequenzunterbandes, um mindestens eine decodierte Restunterkomponente (A'(n,bᵢ)) zu synthetisieren,
- Zerlegung der decodierten Hauptkomponente (CP') in mindestens eine decodierte Frequenzhauptunterkomponente,
- Umwandlung durch inverse Hauptkomponentenanalyse der mindestens einen decodierten Hauptunterkomponente und der mindestens einen decodierten Restunterkomponente (A'(n,b)) in decodierte Frequenzunterbänder, und
- Kombination der decodierten Frequenzunterbänder, um mindestens zwei decodierte Kanäle (L', R') entsprechend den mindestens zwei Kanälen (L, R), die von dem originalen mehrkanaligen Audiosignal stammen, zu bilden.

11. Verfahren zur Decodierung eines Empfangssignals, umfassend ein codiertes Audiosignal, das nach einem der Ansprüche 7 bis 9 aufgebaut ist, **dadurch gekennzeichnet, dass** es die folgenden Schritte umfasst:
- Empfang des codierten Audiosignals (SC),
- Extraktion einer decodierten Hauptkomponente (y') und mindestens eines decodierten Umwandlungsparameters,
- Decodierung mindestens einer Reststruktur eines Frequenzunterbandes, um mindestens eine decodierte Restunterkomponente (r') zu synthetisieren,
- Bildung von mindestens zwei decodierten Kanälen (L', R') entsprechend den mindestens zwei Kanälen (L, R), die von dem originalen mehrkanaligen Audiosignal stammen, durch inverse Hauptkomponentenanalyse in Abhängigkeit von dem mindestens einen decodierten Umwandlungsparameter, der decodierten Hauptkomponente (y') und der mindestens einen decodierten Restunterkomponente (r').

12. Skalierbarer Codierer eines mehrkanaligen Audiosignals, umfassend Mittel zur Umwandlung (28) durch Hauptkomponentenanalyse (ACP), um mindestens zwei Kanäle (L, R) des Audiosignals in eine Hauptkomponente (CP) und mindestens eine Restunterkomponente durch durch einen Umwandlungsparameter (θ(n,bᵢ)) definierte Rotation umzuwandeln, **dadurch gekennzeichnet, dass** die Umwandlungsmittel durch Hauptkomponentenanalyse im Frequenzbereich sind, um mindestens eine Frequenzrestunterkomponente (A(n,bᵢ)) zu erhalten, und dass er umfasst:
- Mittel zur Bildung (30) einer Struktur, um eine Reststruktur (Sfᵣ(n,b)) pro Frequenzunterband durch Filtermittel zu bilden, umfassend eine Filterbank (31), um die mindestens eine Frequenzrestunterkomponente zu filtern, und
- Mittel zur Definition (29), um ein codiertes Audiosignal zu definieren, umfassend die Hauptkomponente (CP), mindestens die Reststruktur (Sfᵣ(n,b)) mindestens eines Frequenzunterbandes in einer bestimmten Übertragungsreihenfolge der Reststrukturen der Frequenzunterbänder und den Umwandlungsparameter (θ(n,bᵢ)).

13. Skalierbarer Codierer eines mehrkanaligen Audiosignals, umfassend Mittel zur Umwandlung (28) durch Hauptkomponentenanalyse (ACP), um mindestens zwei Kanäle (L, R) des Audiosignals in eine Hauptkomponente und mindestens eine Restunterkomponente (r) durch durch einen Umwandlungsparameter (α) definierte Rotation umzuwandeln, **dadurch gekennzeichnet, dass** er umfasst:
- Umwandlungsmittel (16) zum Anlegen einer Kurzzeit-Fourier-Transformation (TFCT) an die mindestens eine Restunterkomponente (r), um mindestens eine Frequenzrestunterkomponente zu bilden,
- Filtermittel, umfassend eine Frequenzfilterbank (31), um die mindestens eine Frequenzrestunterkomponente zu filtern, um Reststrukturen (Sfᵣ) der Frequenzunterbänder zu erhalten, und
- Definitionsmittel (29), um ein codiertes Audiosignal (SC) zu definieren, umfassend die Hauptkomponente, mindestens die Reststruktur (Sfᵣ) mindestens eines Frequenzunterbandes in einer bestimmten Übertragungsreihenfolge der Reststrukturen der Frequenzunterbänder und den Umwandlungsparameter (α).

14. Skalierbarer Decodierer eines Empfangssignals, umfassend ein codiertes Audiosignal, das nach einem der Ansprüche 1 bis 6 aufgebaut ist, **dadurch gekennzeichnet, dass** er umfasst:
- Mittel zum Empfangen eines codierten Audiosignals (SC(n)),
- Mittel zur Extraktion einer decodierten Hauptkomponente (CP') und mindestens eines decodierten Umwandlungsparameters,
- Mittel zur Frequenzsynthese 45, um mindestens eine Reststruktur (Sfᵣ(n,b)) eines Frequenzunterbandes zu decodieren, um mindestens eine decodierte Restunterkomponente (A'(n,bᵢ)) zu synthetisieren,
- Mittel zur Zerlegung der decodierten Hauptkomponente (CP') in mindestens eine decodierte Frequenzhauptunterkomponente,
- Mittel zur Umwandlung durch inverse Hauptkomponentenanalyse, um die mindestens eine decodierte Hauptunterkomponente und die mindestens eine decodierte Restunterkomponente (A'(n,b)) in decodierte Frequenzunterbänder umzuwandeln, und
- Mittel zur Kombination der decodierten Frequenzunterbänder, um mindestens zwei decodierte Kanäle (L', R') zu bilden, die den mindestens zwei Kanälen (L, R) entsprechen, die von dem originalen mehrkanaligen Audiosignal stammen.

15. Skalierbarer Decodierer eines Empfangssignals, umfassend ein codiertes Audiosignal, das nach einem der Ansprüche 7 bis 9 aufgebaut ist, **dadurch gekennzeichnet, dass** er umfasst:
- Mittel zum Empfangen eines codierten Audiosignals (SC),
- Mittel zur Extraktion einer decodierten Hauptkomponente (y') und mindestens eines decodierten Umwandlungsparameters,
- Mittel zur Frequenzsynthese 45, um mindestens eine Reststruktur eines Frequenzunterbandes zu decodieren, um mindestens eine decodierte Restunterkomponente (r') zu synthetisieren,
- Mittel zur Bildung mindestens zweier decodierter Kanäle (L', R'), entsprechend den mindestens zwei Kanälen (L, R), die von dem originalen mehrkanaligen Audiosignal stammen, durch inverse Hauptkomponentenanalyse in Abhängigkeit von mindestens einem decodierten Umwandlungsparameter, der decodierten Hauptkomponente (y') und der mindestens einen decodierten Restunterkomponente (r').

16. Computerprogramm, das von einem Kommunikationsnetz fernladbar und/oder auf einem von einem Computer lesbaren Träger gespeichert und/oder von einem Mikroprozessor ausführbar ist, **dadurch gekennzeichnet, dass** es Programmcodebefehle für die Ausführung der Schritte des Codierungsverfahrens nach mindestens einem der Ansprüche 1 bis 9, wenn es auf einem Computer oder Mikroprozessor ausgeführt wird, umfasst.

17. Computerprogramm, das von einem Kommunikationsnetz fernladbar und/oder auf einem von einem Computer lesbaren Träger gespeichert und/oder von einem Mikroprozessor ausführbar ist, **dadurch gekennzeichnet, dass** es Programmcodebefehle für die Ausführung der Schritte des Decodierungsverfahrens nach mindestens einem der Ansprüche 10 bis 11, wenn es auf einem Computer oder Mikroprozessor ausgeführt wird, umfasst.

## Claims

1. Method for scalable coding of a multichannel audio signal comprising a transformation by principal component analysis (PCA) of at least two channels (L, R) of said audio signal into a principal component (PC) and at least one residual subcomponent by rotation defined by a transformation parameter (θ(n,bᵢ)), **characterized in that** said at least one residual subcomponent is a frequency residual subcomponent (A(n,bᵢ)) produced according to a principal component analysis in the frequency domain, and **in that** the method comprises the following steps:
- formation of a residual structure (Sfᵣ(n,b)) per frequency subband by filtering, by a filter bank, said at least one frequency residual subcomponent, and
- definition of a coded audio signal comprising said principal component (PC), the residual structure (Sfᵣ(n,b)) of at least one frequency subband according to a determined order of transmission of the residual structures of the frequency subbands and said transformation parameter (θ(n,bᵢ)).

2. Method according to Claim 1, **characterized in that** it comprises a formation of at least one energy parameter as a function of said at least one frequency residual subcomponent.

3. Method according to Claim 2, **characterized in that** said at least one energy parameter is formed by an extraction of energy difference by frequency subband between a decomposition of said principal component (PC) and said at least one frequency residual subcomponent.

4. Method according to Claim 2, **characterized in that** said at least one energy parameter corresponds to an in-subband energy of said at least one frequency residual subcomponent.

5. Method according to Claim 1, **characterized in that** the transformation by principal component analysis (PCA) into the frequency domain comprises the following steps:
- decomposing said at least two channels (L, R) of said audio signal into a plurality of frequency subbands,
- computing said at least one transformation parameter (θ(n,bᵢ)) as a function of at least a part of said plurality of frequency subbands,
- transforming at least a part of said plurality of frequency subbands into said at least one frequency residual subcomponent and at least one frequency principal subcomponent as a function of said at least one transformation parameter, and
- forming said principal component from said at least one frequency principal subcomponent.

6. Method according to Claim 5, **characterized in that** said plurality of frequency subbands is defined according to a perceptual scale.

7. Method for the scalable encoding of a multichannel audio signal comprising a transformation by principal component analysis (PCA) of at least two channels (L, R) of said audio signal into a principal component and at least one residual subcomponent (r) by rotation defined by a transformation parameter (α), **characterized in that** it comprises the following steps:
- application of a short-term Fourier transform (STFT) to said at least one residual subcomponent (r) to form at least one frequency residual subcomponent,
- filtering of said at least one frequency residual subcomponent by a frequency filter bank to obtain residual structures (Sfᵣ) of the frequency subbands, and
- definition of a coded audio signal (CS) comprising said principal component, the residual structure (Sfᵣ) of at least one frequency subband according to a determined order of transmission of the residual structures of the frequency subbands and said transformation parameter (α).

8. Method according to either one of Claims 1 and 7, **characterized in that** said determined order of transmission is produced according to a perceptual order of the subbands or an energy criterion or according to a correlation of the components deriving from the principal component analysis in subbands.

9. Method according to any one of Claims 1 to 8, **characterized in that** it comprises a correlation analysis between said at least two channels (L, R) to determine a corresponding correlation value, and **in that** said coded audio signal further comprises said correlation value.

10. Method for decoding a reception signal comprising a coded audio signal constructed according to any one of Claims 1 to 6, **characterized in that** it comprises the following steps:
- receiving the coded audio signal (CS(n)),
- extracting a decoded principal component (PC') and at least one decoded transformation parameter,
- decoding at least one residual structure (Sfᵣ(n,b)) of a frequency subband to synthesise at least one decoded residual subcomponent (A'(n,bᵢ)),
- decomposing said decoded principal component (PC') into at least one decoded frequency principal subcomponent,
- transforming, by inverse principal component analysis, said at least one decoded principal subcomponent and said at least one decoded residual subcomponent (A'(n,b)) into decoded frequency subbands,
and
- combining said decoded frequency subbands to form at least two decoded channels (L', R') corresponding to said at least two channels (L, R) deriving from said original multichannel audio signal.

11. Method for decoding a reception signal comprising a coded audio signal constructed according to any one of Claims 7 to 9, **characterized in that** it comprises the following steps:
- receiving the coded audio signal (CS),
- extracting a decoded principal component (y') and at least one decoded transformation parameter,
- decoding at least one residual structure of a frequency subband to synthesise at least one decoded residual subcomponent (r'),
- forming at least two decoded channels (L', R') corresponding to said at least two channels (L, R) deriving from said original multichannel audio signal, by inverse principal component analysis as a function of said at least one decoded transformation parameter, of said decoded principal component (y') and of said at least one decoded residual subcomponent (r').

12. Scalable encoder for a multichannel audio signal, comprising transformation means (28) by principal component analysis (PCA) for transforming at least two channels (L, R) of said audio signal into a principal component (PC) and at least one residual subcomponent by rotation defined by a transformation parameter (n,bᵢ), **characterized in that** the transformation means by principal component analysis are in the frequency domain to obtain at least one frequency residual subcomponent (A(n,bᵢ)) and **in that** it comprises:
- structure forming means (30) for forming a residual structure (Sfᵣ(n,b)) per frequency subband by filtering means comprising a filter bank (31) for filtering said at least one frequency residual subcomponent, and
- definition means (29) for defining a coded audio signal comprising said principal component (PC), at least the residual structure (Sfᵣ(n,b)) of at least one frequency subband according to a determined order of transmission of the residual structures of the frequency subbands and said transformation parameter (θ(n,bᵢ)).

13. Scalable encoder for a multichannel audio signal, comprising transformation means (28) by principal component analysis (PCA) for transforming at least two channels (L, R) of said audio signal into a principal component and at least one residual subcomponent (r) by rotation defined by a transformation parameter (α), **characterized in that** it comprises:
- transformation means (16) for applying a short-term Fourier transform (STFT) to said at least one residual subcomponent (r) to form at least one frequency residual subcomponent,
- filtering means comprising a frequency filter bank (31) for filtering said at least one frequency residual subcomponent to obtain residual structures (Sfᵣ) of the frequency subbandd, and
- definition means (29) for defining a coded audio signal (CS) comprising said principal component, at least the residual structure (Sfᵣ) of at least one frequency subband according to a determined order of transmission of the residual structures of the frequency subbands and said transformation parameter (α).

14. Scalable decoder for a reception signal comprising a coded audio signal constructed according to any one of Claims 1 to 6, **characterized in that** it comprises:
- means for receiving a coded audio signal (CS(n)),
- means for extracting a decoded principal component (PC') and at least one decoded transformation parameter,
- frequency synthesis means 45 for decoding at least one residual structure (Sfᵣ(n,b)) of a frequency subband to synthesise at least one decoded residual subcomponent (A'(n,bi)),
- means for decomposing said decoded principal component (PC') into at least one decoded frequency principal subcomponent,
- transformation means by inverse principal component analysis for transforming said at least one decoded principal subcomponent and said at least one decoded residual subcomponent (A'(n,b)) into decoded frequency subbands, and
- means for combining said decoded frequency subbands to form at least two decoded channels (L', R') corresponding to said at least two channels (L, R) deriving from said original multichannel audio signal.

15. Scalable decoder for a reception signal comprising a coded audio signal constructed according to any one of Claims 7 to 9, **characterized in that** it comprises:
- means for receiving a coded audio signal (CS),
- means for extracting a decoded principal component (y') and at least one decoded transformation parameter,
- frequency synthesis means 45 for decoding at least one residual structure of a frequency subband to synthesise at least one decoded residual subcomponent (r'),
- means for forming at least two decoded channels (L', R') corresponding to said at least two channels (L, R) deriving from said original multichannel audio signal, by inverse principal component analysis as a function of said at least one decoded transformation parameter, of said decoded principal component (y') and of said at least one decoded residual subcomponent (r').

16. Computer program that can be downloaded from a communication network and/or stored on a computer-readable medium and/or that can be executed by a microprocessor, **characterized in that** it comprises program code instructions for executing the steps of the coding method according to at least one of Claims 1 to 9, when it is run on a computer or a microprocessor.

17. Computer program that can be downloaded from a communication network and/or stored on a computer-readable medium and/or that can be executed by a microprocessor, **characterized in that** it comprises program code instructions for executing the steps of the decoding method according to at least one of Claims 10 to 11, when it is run on a computer or a microprocessor.
